# DEMANDE DE BREVET EUROPEEN

(11) **EP 4 311 053 A1**
(43) Date de publication de la demande: **24.01.2024**
(21) Numéro de dépôt: 23185749.1
(22) Date de dépôt: 17.07.2023
(51) Int. Cl.: H02H 3/06

(54) **MODULE DE DÉTECTION D'UN DÉFAUT ÉLECTRIQUE POUR UN APPAREIL DE PROTECTION ÉLECTRIQUE ET PROCÉDÉ CORRESPONDANT**

(30) Priorité: 18.07.2022 FR 2207337
(71) Demandeur: SCHNEIDER ELECTRIC INDUSTRIES SAS, 92500 Rueil-Malmaison (FR)
(72) Inventeur: BROQUIE, Vincent, 38130 ECHIROLLES (FR); TIAN, Simon, 38330 SAINT ISMIER (FR); MEUNIER-CARUS, Jérôme, 38100 GRENOBLE (FR)
(74) Mandataire: Lavoix

(57) **Abrégé**

Ce module (12) de détection d'un défaut électrique pour un appareil de protection électrique (4), adapté pour interrompre l'alimentation électrique d'au moins une charge, est configuré pour être connecté en parallèle de l'appareil de protection et comporte un circuit de traitement, un commutateur d'isolement et une unité électronique de commande (13) pour commander le fonctionnement du commutateur d'isolement. L'unité de commande ferme le commutateur d'isolement et injecte une séquence de signaux de test dans les pôles du circuit de traitement lors de la détection d'une interruption de l'alimentation par l'appareil de protection électrique. Le circuit de traitement fournit au circuit de commande une séquence de signaux de tension proportionnels à des impédances de défaut selon le signal de test injecté par le module de commande. L'actionneur provoque la reconnexion de l'alimentation électrique par l'appareil de protection électrique si les valeurs d'impédance du circuit aval calculées par l'unité de commande à partir des signaux de tension indiquent l'absence de défaut électrique dans l'installation électrique.

## Description

La présente invention concerne un module de détection d'un défaut électrique pour un appareil de protection électrique et un procédé correspondant.

Dans les installations de distribution électrique, il est courant d'utiliser des dispositifs de protection électrique tels que des disjoncteurs, notamment des disjoncteurs miniatures, ou des appareils de protection différentielle, par exemple.

Ces appareils de protection permettent de déconnecter tout ou partie de l'installation électrique afin de protéger l'installation contre un défaut électrique.

Il arrive parfois que des déclenchements intempestifs occasionnels de ces appareils de protection se produisent en raison de perturbations du réseau ou de défauts transitoires.

Dans ce cas, les charges électriques connectées à l'installation électrique perdent leur alimentation électrique et cessent de fonctionner. Des interruptions prolongées de l'alimentation électrique sont à éviter et peuvent avoir des conséquences adverses.

Pour pallier à cela, il est prévu, pour certains circuits critiques, que l'appareil de protection qui s'est déclenché puisse se refermer automatiquement, afin de rétablir l'alimentation électrique, s'il est avéré qu'aucun défaut électrique et notamment qu'aucun défaut de terre ou de court-circuit n'est présent dans l'installation.

EP 1744428 A2 décrit une méthode d'évaluation des défauts par des mesures de l'impédance entre les pôles de phase et de neutre et une mesure du courant de fuite à la terre en courant continu et en courant alternatif. DE102008005687A1 divulgue un dispositif de commande pour réenclencher un disjoncteur différentiel suite à un défaut différentiel. Ces méthodes connues ne donnent cependant pas entière satisfaction.

C'est à ces inconvénients qu'entend plus particulièrement remédier l'invention en proposant un module de détection d'un défaut électrique pour un appareil de protection électrique permettant de vérifier si l'appareil électrique peut être réenclenché en toute sécurité.

A cet effet, l'invention concerne un module de détection d'un défaut électrique pour un appareil de protection électrique, ledit appareil de protection électrique étant adapté pour interrompre l'alimentation électrique d'une ou de plusieurs charge(s) électrique(s) connectée(s) dans une installation électrique en aval de l'appareil de protection lors de la détection d'un défaut électrique par l'appareil de protection électrique, l'installation électrique comprenant au moins deux pôles et comprenant, en aval de l'appareil de protection, un circuit électrique dit aval comprenant la ou les plusieurs charge(s) électrique(s), le module de détection étant configuré pour être connecté en parallèle de l'appareil de protection et comportant :
- un circuit de traitement apte à identifier un défaut électrique, le circuit de traitement étant connectable aux pôles de l'installation électrique en amont dudit appareil de protection électrique ;
- un commutateur d'isolement adapté à être connecté entre les pôles du circuit de traitement et l'installation électrique ;
- une unité électronique de commande agencée pour commander le fonctionnement du commutateur d'isolement ;

Dans ce module de détection, l'unité de commande est agencée pour fermer le commutateur d'isolement et injecter une séquence de différents signaux de test dans les pôles du circuit de traitement lors de la détection d'une interruption de l'alimentation électrique par l'appareil de protection électrique. Le circuit de traitement est agencé pour fournir au circuit de commande une séquence de signaux de tension proportionnels à des impédances de défaut selon le signal de test injecté par le module de commande. En outre, un actionneur est agencé pour provoquer la reconnexion de l'alimentation électrique par l'appareil de protection électrique si les valeurs d'impédance du circuit aval calculées par l'unité de commande à partir des signaux de tension indiquent l'absence de défaut électrique dans l'installation électrique.

Selon des aspects avantageux mais non obligatoires, un tel module de détection d'un défaut électrique peut incorporer une ou plusieurs des caractéristiques suivantes, prises isolément ou suivant toute combinaison techniquement admissible.
- Les impédances de défaut comportent une impédance de terre sous tension entre la terre et une ligne de phase en aval de l'appareil de protection, une impédance de terre neutre entre la terre et une ligne de neutre en aval de l'appareil de protection et une impédance de charge entre deux pôles en aval de l'appareil de protection.
- L'actionneur est adapté à être connecté audit appareil de protection électrique, la reconnexion de l'alimentation électrique par l'appareil de protection étant réalisée par l'actionneur en commutant les contacts séparables de l'appareil de protection vers leur état fermé.
- Le circuit de traitement comporte un pont de diodes redresseur et des résistances internes chacune connectée en série sur un des pôles entre le pont de diodes et une sortie du circuit de traitement raccordée au circuit aval, le circuit de traitement étant agencé pour que l'injection de différents signaux de test soit réalisée en connectant et déconnectant sélectivement et successivement certaines parties du circuit de traitement.
- Les pôles comportent au moins une ligne de phase et une ligne de neutre, et dans lequel l'unité électronique de commande est configurée pour que, lors d'une première séquence de test, un premier signal de test est injecté lorsque seule la résistance interne associée à la ligne de phase est connectée dans le circuit de traitement et que la résistance interne associée à la ligne de neutre est déconnectée.
- L'unité électronique de commande est configurée pour que, lors d'une deuxième séquence, un deuxième signal de test est injecté lorsque seule la résistance interne associée à la ligne de neutre est connectée dans le circuit de traitement et que la résistance interne associée à la ligne de phase est déconnectée.
- L'unité électronique de commande est configurée pour que, lors d'une troisième séquence, un troisième signal de test est injecté lorsque les résistances internes sont toutes deux connectées dans le circuit de traitement pour mesurer directement l'impédance de court-circuit.

Selon un autre aspect, l'invention concerne un ensemble comportant un appareil de protection électrique et un module de détection d'un défaut électrique tel que décrit précédemment, le module de détection étant intégré au sein de l'appareil de protection électrique.

Selon une variante, le module de détection est intégré dans un module indépendant et associé électriquement et/ou mécaniquement à l'appareil de protection électrique.

La présente invention vise en outre un procédé de détection d'un défaut électrique pour un appareil de protection électrique, le module étant tel que décrit précédemment, dans lequel le procédé de détection comporte des étapes consistant à :
- fermer le commutateur d'isolement et injecter une séquence de différents signaux de test dans les pôles du circuit de traitement lors de la détection d'une interruption de l'alimentation électrique par l'appareil de protection électrique,
- fournir au circuit de commande, par le circuit de traitement, une séquence de signaux de tension proportionnels à des impédances de défaut selon le signal de test injecté par le module de commande,
- provoquer la reconnexion de l'alimentation électrique par l'appareil de protection électrique si les impédances de défaut calculées par l'unité de commande à partir des signaux de tension indiquent l'absence de défaut électrique dans l'installation électrique.

L'invention sera mieux comprise et d'autres avantages de celle-ci apparaîtront plus clairement à la lumière de la description qui va suivre d'un mode de réalisation d'un module de détection d'un défaut électrique, cette description étant donnée uniquement à titre d'exemple et faite en référence aux dessins annexés, dans lesquels :
[Fig 1] la figure 1 est un schéma simplifié d'un système de protection électrique comportant un module de détection d'un défaut électrique conforme à l'invention ;
[Fig 2] la figure 2 est un schéma synoptique simplifié illustrant une première étape de fonctionnement du système de protection électrique de la figure 1 ;
[Fig 3] la figure 3 est un schéma synoptique simplifié illustrant une deuxième étape de fonctionnement du système de protection électrique de la figure 1 ;
[Fig 4] la figure 4 est un schéma synoptique simplifié illustrant une troisième étape de fonctionnement du système de protection électrique de la figure 1 ;
[Fig 5] la figure 5 est un schéma synoptique simplifié illustrant une quatrième étape de fonctionnement du système de protection électrique de la figure 1 ;
[Fig 6] la figure 6 représente schématiquement un exemple d'un procédé de fonctionnement du système de protection électrique des figures 1 à 5.

Pour décrire de manière claire et concise la présente invention, les dessins ne sont pas nécessairement à l'échelle et certaines caractéristiques peuvent être présentées sous une forme schématique.

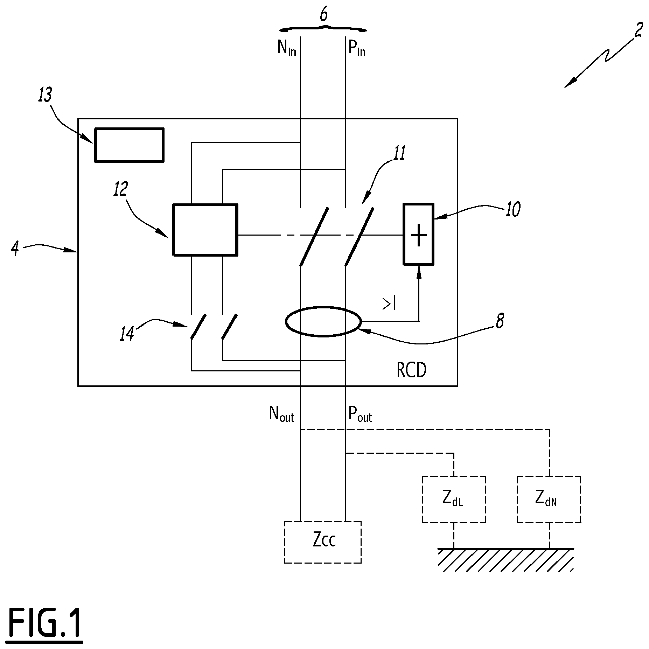

La figure 1 représente une installation électrique 2 dans laquelle est connecté un appareil de protection électrique 4 comportant un module de détection 12 conforme à des modes de réalisation selon l'invention.

L'installation 2 est, par exemple, une installation de distribution d'électricité utilisée pour alimenter une ou plusieurs charges électriques avec une tension électrique fournie par une source électrique, telle qu'un réseau public d'électricité. L'installation comporte au moins deux pôles, voire plus, selon que l'installation est monophasée ou polyphasée (par exemple, triphasée) et selon qu'une ligne de neutre est présente ou non.

Par exemple, l'installation 2 comporte des conducteurs électriques 6 permettant la circulation d'un courant électrique, de préférence un courant électrique alternatif (AC) monophasé ou polyphasé.

Dans l'exemple illustré, l'installation 2 est une installation monophasée avec neutre et comporte à ce titre une ligne de phase (Pᵢₙ, Pₒᵤₜ, notée L dans ce qui suit) et une ligne de neutre (Nᵢₙ, Nₒᵤₜ, notée N dans ce qui suit). Cet exemple n'est cependant pas limitatif. En variante, l'installation pourrait comporter un nombre différent de conducteurs 6, par exemple pour accommoder des courants polyphasés, notamment triphasés, avec ou sans neutre.

L'appareil de protection 4 est ici connecté en amont de la source électrique (sur ses entrées Nᵢₙ et Pᵢₙ) et en aval de ou des charges électriques (sur ses sorties Nₒᵤₜ et Pₒᵤₜ).

De façon générale, l'appareil de protection 4 est destiné à protéger des équipements électriques tels que des charges électriques et/ou l'installation 2 elle-même contre des défauts électriques tels que des surtensions, des courts circuits ou des défauts différentiels.

Dans ce qui suit, on désignera par l'appellation « circuit électrique aval » la portion de l'installation électrique 2 qui se trouve connectée en aval de l'appareil de protection 4 (par exemple du côté de la sortie de l'appareil de protection 4) et qui comporte au moins une desdites charges électriques.

Sur la figure 1, les défauts électriques susceptibles d'apparaître dans l'installation 2, en aval de l'appareil de protection, sont représentées schématiquement par des blocs d'impédances Zcc, Z_{dN} et Z_{dL}.

L'impédance Zcc connectée entre deux pôles correspond à un défaut de basse impédance ou de court-circuit. Les impédances Z_{dN} et Z_{dL} connectées entre un pôle et la terre correspondent, respectivement, à un défaut de fuite sur la ligne de neutre (impédance terre neutre) et à un défaut de fuite sur la ligne de phase (impédance terre phase).

L'appareil de protection 4 est ici un appareil de protection différentielle (RCD, pour « residual current device » en anglais), mais cet exemple n'est pas limitatif et d'autres exemples sont possibles. Par exemple, en variante, l'appareil de protection 4 pourrait être un disjoncteur.

De façon générale, l'appareil de protection 4 comporte un élément de mesure 8, un déclencheur 10 et des contacts électriques séparables 11 qui raccordent les bornes d'entrée (Ni, et Pᵢₙ) aux bornes de sortie (Nₒᵤₜ et Pₒᵤₜ) de l'appareil de protection 4.

Les contacts séparables 11 sont commutables, réversiblement et sélectivement, entre un état fermé, dans lequel l'appareil de protection 4 laisse passer le courant, et un état ouvert, dans lequel l'appareil de protection 4 empêche le passage du courant.

L'élément de mesure 8, qui peut comporter un capteur, notamment un capteur de courant ou de tension, de préférence associé aux conducteurs 6, est configuré pour détecter un défaut électrique dans l'installation 2. Le déclencheur 10 est apte à déclencher la commutation des contacts électriques 11 vers un état ouvert depuis un état fermé afin de déconnecter le réseau de l'installation 2 lorsqu'un défaut électrique est détecté grâce à l'élément de mesure 8.

Dans l'exemple, l'élément de mesure 8 est un tore de mesure différentielle qui entoure les conducteurs électriques 6 des lignes de neutre et de phase.

On comprend toutefois que la nature de l'élément de mesure 8 et du déclencheur 10 peuvent être différentes en fonction de la nature de l'appareil de protection 4. Par exemple, si l'appareil de protection 4 est un disjoncteur au lieu d'un appareil de protection différentielle, alors l'élément de mesure 8 et/ou le déclencheur 10 peuvent être au moins en partie remplacés par un déclencheur magnétothermique. D'autres modes de réalisation sont bien évidemment possibles.

Le module de détection 12 est ici connecté électriquement en parallèle de l'appareil de protection 4.

Dans les modes de réalisation illustrés, le module de détection est intégré au sein de l'appareil de protection 4, par exemple dans un même boîtier que l'appareil de protection 4.

Mais en variante, le module de détection pourrait être intégré dans un module indépendant et associé électriquement et/ou mécaniquement à l'appareil de protection électrique, Par exemple le module de détection pourrait être un module externe amovible connecté à l'appareil de protection 4. Le module externe pourrait alors comporter son propre boîtier, avec de préférence des moyens de fixation, permettant la fixation de ce boîtier sur un rail de fixation aux côtés de l'appareil de protection 4, ou directement sur un boîtier de l'appareil de protection 4. De préférence, le cas échéant, le boîtier propre du module externe présente une largeur normalisée, par exemple 18mm de large ou 36mm de large, pour faciliter l'installation dans des tableaux électriques.

Selon des modes de réalisation, le module de détection 12 comporte :
- un circuit de traitement apte à identifier un défaut électrique, le circuit de traitement étant connectable aux pôles de l'installation électrique 2 de préférence en amont dudit appareil de protection électrique 4,
- un actionneur (non illustré en détail) pouvant être connecté audit appareil de protection électrique 4,
- un commutateur d'isolement 14 pouvant être connecté entre les pôles du circuit de traitement et l'installation électrique, de préférence en un point situé en aval dudit appareil de protection électrique 4 et en amont des charges électriques à protéger ;
- une unité électronique de commande 13 couplée à l'actionneur, au circuit de traitement et au commutateur d'isolement 14.

Le commutateur d'isolement 14 comporte ici des contacts séparables pour chaque pôle, ici pour le neutre et pour la phase.

Le commutateur d'isolement 14 est commutable entre un état fermé, dans lequel le circuit de traitement se trouve connecté aux pôles de l'installation électrique 2 de préférence en amont dudit appareil de protection électrique 4, et un état ouvert, dans lequel le circuit de traitement est déconnecté de l'installation 2 et notamment les pôles (neutre et phase) du circuit de traitement sont déconnectés des pôles correspondants de l'appareil de protection 4. De préférence, sa fermeture ne se réalise que lorsque les contacts 6 sont à l'état ouvert.

Le module de détection comporte de préférence une alimentation en énergie capable de fournir de l'énergie électrique à l'unité de commande. Il peut s'agir d'énergie électrique prélevée depuis un point de connexion situé en amont de l'appareil de protection 4. L'alimentation électrique comporte de préférence des éléments de protection électrique tel qu'un fusible et/ou un dispositif de protection contre les surtensions et/ou un filtre de protection contre les perturbations électromagnétiques.

L'actionneur est par exemple couplé au déclencheur 10 et/ou aux contacts 11 en vue de causer la commutation des contacts électriques séparables 11, notamment pour refermer les contacts 11. Le couplage peut être permanent lorsque le module de détection est intégré à l'appareil 4. Le couplage peut en revanche être réversible lorsque le module de détection est un appareil amovible destiné à se connecter par l'extérieur de l'appareil de protection 4.

L'actionneur est, par exemple, un actionneur électromécanique, tel qu'un actionneur linéaire ou un moteur électrique.

L'unité électronique de commande 13 est agencée pour commander le fonctionnement du commutateur d'isolement et de l'actionneur.

Par exemple, l'unité électronique de commande 13 comporte un processeur, tel qu'un microcontrôleur ou un microprocesseur. Cela ne fait pas obstacle à ce que, en variante, au moins une partie des fonctions de l'unité de commande soient réalisées par d'autres composants électroniques, tels qu'un processeur de traitement du signal (DSP), ou un composant logique reprogrammable (FPGA), ou un circuit intégré spécialisé (ASIC), ou tout élément équivalent, ou toute combinaison de ces éléments.

De façon générale, le module de détection 12 a pour fonction de vérifier, après un déclenchement de l'appareil de protection 4, si un défaut électrique est toujours présent dans l'installation ou non, afin de, le cas échéant, réarmer l'appareil de protection 4, c'est-à-dire commuter les contacts mobiles 11 de l'appareil de protection 4 vers l'état fermé afin de rétablir l'alimentation électrique dans l'installation électrique 2.

Pour ce faire, le module de détection 12 mesure automatiquement les impédances Zcc, Z_{dN} et Z_{dL} précédemment décrites en vue de déterminer la présence ou l'absence de défauts électriques.

Si aucun de ces défauts électriques n'est présent dans l'installation 2, par exemple parce que l'appareil de protection 4 a été déclenché par erreur ou par un défaut transitoire qui a entre-temps disparu, alors l'appareil de protection 4 peut être refermé.

Au contraire, si un défaut électrique est détecté comme étant toujours présent dans l'installation 2, alors l'appareil de protection 4 n'est pas refermé et reste dans l'état ouvert pour déconnecter les charges de l'alimentation électrique.

De préférence, le module de détection doit également assurer la non injection de signaux dans le cadre d'opération de cadenassage (neutralisation de l'appareil de protection 4) lors d'intervention de maintenance ou de réparation par les clients.

De façon générale, l'unité électronique de commande 13 est configurée pour :
- fermer le commutateur d'isolement 14 et injecter une séquence de différents signaux de test dans les pôles du circuit de traitement lors de la détection d'une interruption dudit réseau d'alimentation électrique par l'appareil de protection électrique,
- fournir une séquence de signaux de tension proportionnels à des impédances de défaut selon le signal de test injecté par le module de commande,
- provoquer la reconnexion dudit réseau d'alimentation électrique audit circuit électrique par l'appareil de protection électrique si les impédances de défaut calculées par l'unité de commande à partir des signaux de tension indiquent l'absence de défaut électrique dans l'installation électrique.

Par exemple, comme indiqué précédemment, les impédances de défaut comportent une impédance de terre sous tension (Z_{dL}) entre la terre et une ligne de phase en aval de l'appareil de protection, une impédance de terre neutre (Z_{dN}) entre la terre et une ligne de neutre en aval de l'appareil de protection et une impédance de charge (Zcc) entre deux pôles en aval de l'appareil de protection.

En d'autres termes, pour déterminer la valeur de l'impédance du circuit électrique aval, on injecte successivement un signal de test sur chaque pôle du réseau électrique en amont du circuit, puis on injecte ensuite un signal de test sur tous les pôles.

Par exemple, au total, cela correspond ainsi à 3 séquences d'injection maximum pour un dispositif à 2 pôles, d'autres exemples étant cependant possibles.

Après chaque injection, un algorithme détermine l'impédance du circuit en aval et arrête ou continue les séquences d'injection en fonction du résultat. Le dispositif de sécurité est alors réarmé, ou non, en fonction du résultat déterminé par l'algorithme.

La reconnexion de l'alimentation électrique par l'appareil de protection est par exemple réalisée par l'actionneur en commutant les contacts séparables 11 de l'appareil de protection vers leur état fermé, par exemple grâce à un couplage mécanique entre l'actionneur et les contacts ou entre l'actionneur et le déclencheur 10.

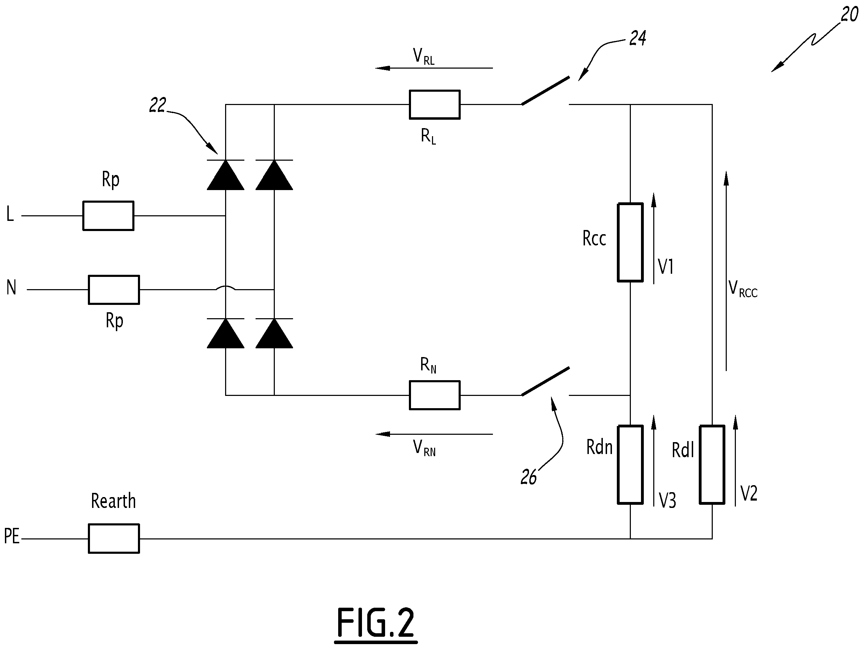

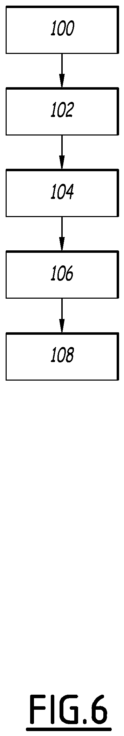

Un exemple de fonctionnement est maintenant illustré sur les figures 2 à 5 et à l'aide de la figure 6.
La figure 2 illustre plus particulièrement un exemple simplifié d'implémentation du circuit de traitement 20 du module de détection 12.

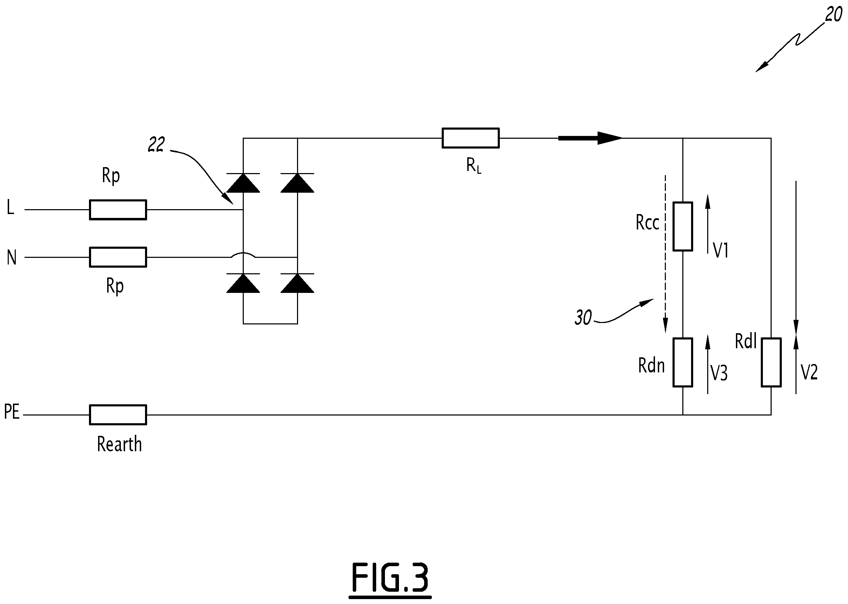

Les figures 3 à 5 sont similaires à la figure 2 et seules les différences notables survenant lors des différentes étapes de fonctionnement du module seront commentées en détail.

Le circuit de traitement 20 comporte un pont de diodes 22 redresseur et des résistances internes Rp, , R_{L} et R_{N}.

Comme on le comprendra dans ce qui suit, les tensions mesurées aux bornes des résistances Rcc, Rdn et Rdl peuvent être déterminées au moyen de l'unité électronique de commande 13.

Le pont de diodes 22 est connecté à des bornes d'entrée alimentées par les lignes de phase P et de neutre N en permanence car ces dernières sont connectées en amont des contacts séparables de l'appareil de protection. Les commutateurs 14 n'ont que la fonction de se connecter aux bornes aval de l'appareil de protection.

On comprend que lorsque les contacts des commutateurs d'isolement 14 sont fermés, le courant provenant de la source d'alimentation peut circuler dans les pôles aval du module de détection, notamment lorsque les contacts mobiles 11 de l'appareil de protection 4 sont ouverts.

Les résistances internes Rp connectées en amont du pont de diode 22 servent à protéger le circuit de traitement 20 contre des surtensions transitoires et contre des perturbations électromagnétiques (CEM). Par exemple, la valeur d'impédance de chacune des résistances internes Rp est égale à 2000 ohms.

Les résistances internes R_{L} et R_{N}, qui sont connectées entre le pont de diode et la sortie du circuit de traitement 20, sont utilisées pour limiter le courant d'injection au niveau de 1mA (ou plus généralement à un niveau de l'ordre du mA, dans une zone de non dangerosité vis-à-vis du risque de choc électrique.). De préférence, la valeur totale des résistances internes de limitation R_{L} et R_{N} est supérieure à 230kOhms pour une tension nominale réseau de 230V AC.

La résistance Rearth correspond à la résistance de la ligne de mise à la terre (PE) de l'installation. Par exemple, la valeur d'impédance de la résistance de terre Rearth est inférieure ou égale à 100 ohm en fonctionnement normal.

Deux thyristors 24 et 26 pilotés par l'unité de commande peuvent être ajoutés dans le circuit de traitement 20. Ces thyristors sont ici optionnels et leur rôle est de donner plus de précision et plus de flexibilité dans la façon de générer la forme d'onde de la tension d'injection.

Dans cet exemple, un premier thyristor 24 est connecté en série avec la résistance interne R_{L} sur la ligne de phase L, tandis qu'un deuxième thyristor 26 est connecté en série avec la résistance interne R_{N} sur la ligne de neutre N. Les thyristors 24 et 26 sont ici montrés dans l'état ouvert.

Sur ce circuit sont également représentées les impédances Zcc, Z_{dN} et Z_{dL} précédemment décrites qui correspondent aux potentiels défauts électriques et dont la valeur doit être déterminées grâce au procédé qui sera décrit ci-après. Ces impédances Zcc, Z_{dN} et Z_{dL} sont représentées sur cette figure par des résistances respectivement notées Rcc, Rdn et Rdl.

Sur la figure 2, les tensions V1, V2 et V3 représentent respectivement les tensions électriques mesurées aux bornes des résistances Rcc, RdL et RdN. Les tensions V_{RL} et V_{RN} représentent respectivement les tensions mesurées aux bornes des résistances internes R_{L} et R_{N}. La tension V_{RCC} représente la tension électrique V1.

Comme on le comprendra à la lecture des exemples qui vont suivre, l'injection de différents signaux de test peut être réalisée en connectant et déconnectant sélectivement et successivement certaines parties du circuit de traitement 20 (et donc en déconnectant tout ou partie des résistances). Le signal électrique injecté n'est autre que le courant électrique provenant du réseau électrique d'alimentation qui est connecté en amont de l'appareil de protection 4. Ces connexions et déconnexions successives sont, par exemple, réalisées avec les thyristors 24 et 26, d'autres implémentations pouvant toutefois être réalisées en variante.

Plus précisément, par exemple, le module 12 a pour fonction de mesurer les impédances de défaut Zcc, Z_{dN} et Z_{dL} précitées, et de déterminer si ces impédances sont suffisamment élevées, signe de l'absence de défaut. Cette détermination peut s'appuyer sur des valeurs de seuil prédéfinies pour chacune des impédances concernées, ces valeurs prédéfinies pouvant être stockées dans une mémoire du module 12.

Dans l'exemple illustré, qui concerne un circuit aval bipolaire avec une ligne de neutre et une ligne de phase, trois séquences d'injection sont mises en oeuvre à tour de rôle.

D'abord, lors d'une première séquence, comme illustré sur la figure 3, un premier signal de test est injecté lorsque seule la résistance interne R_{L} associée à la ligne de phase est connectée dans le circuit de traitement 20. La résistance interne R_{N} associée à la ligne de neutre est alors déconnectée de sorte que le courant électrique ne peut pas y circuler. Le schéma électrique simplifié du circuit de traitement 20 est affiché sur la figure 3, la flèche 30 indiquant le sens de circulation du courant électrique. Par exemple, cela correspond à un état fermé du premier thyristor 24 et un état ouvert du deuxième thyristor 26.

Dans cette séquence est ainsi mesurée l'impédance globale des impédances Zcc+ZdN en parallèle de l'impédance ZdL.

Cette valeur peut être simplifiée dans certains cas extrêmes. Si la charge électrique (du circuit aval) est en circuit ouvert, alors l'impédance Zcc est très grande et la mesure obtenue correspond à l'impédance ZdL. Lorsque la charge électrique (du circuit aval) est en court-circuit, alors l'impédance Zcc est très petite et la mesure obtenue correspond aux impédances ZdL et ZdN connectées en parallèle.

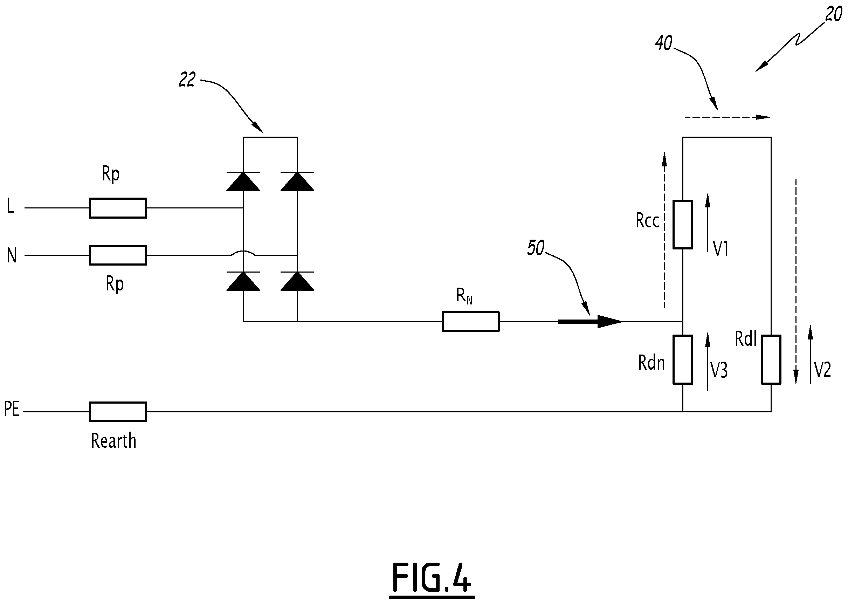

Puis, lors d'une deuxième séquence, comme illustré sur la figure 4, un deuxième signal de test est injecté lorsque seule la résistance interne R_{N} associée à la ligne de neutre est connectée dans le circuit de traitement 20. La résistance interne R_{L} associée à la ligne de phase est alors déconnectée de sorte que le courant électrique ne peut pas y circuler. Le schéma électrique simplifié du circuit de traitement 20 est affiché sur la figure 4, la flèche 40 indiquant le sens de circulation du courant électrique. Par exemple, cela correspond à un état ouvert du premier thyristor 24 et un état fermé du deuxième thyristor 26.

Par exemple, cette séquence peut être omise dans le cas où, à l'issue de la première séquence, il a été déterminé que l'impédance ZdL est inférieure ou égale à un seuil prédéterminé, par exemple 23 kilo ohms.

Dans cette séquence est ainsi mesurée l'impédance globale des impédances Zcc+ZdL en parallèle de l'impédance ZdN.

Cette valeur peut être simplifiée dans certains cas extrêmes. Si la charge électrique (du circuit aval) est en circuit ouvert, alors l'impédance Zcc est très grande et la mesure obtenue correspond à l'impédance ZdN. Lorsque la charge électrique (du circuit aval) est en court-circuit, alors l'impédance Zcc est très petite et la mesure obtenue correspond aux impédances ZdL et ZdN connectées en parallèle.

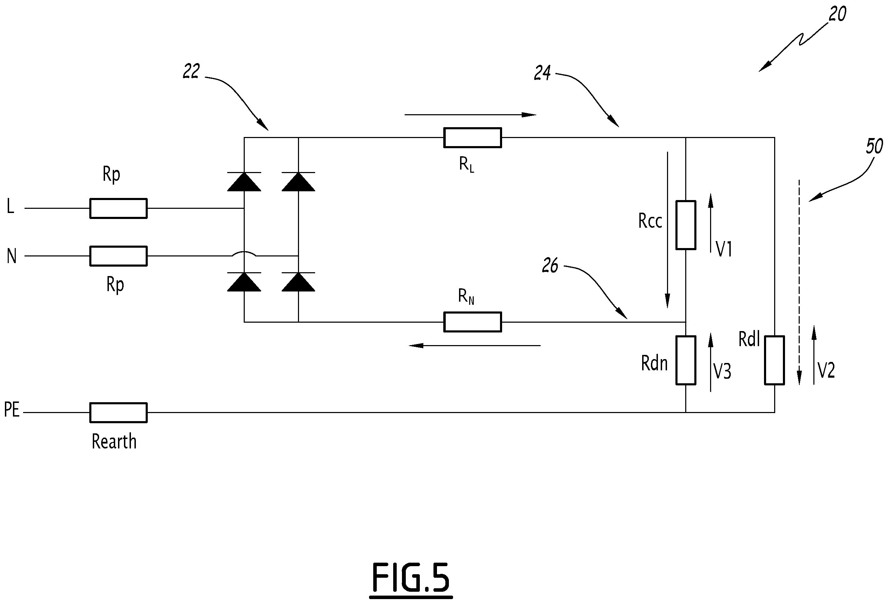

Ensuite, lors d'une troisième séquence, comme illustré sur la figure 5, un troisième signal de test est injecté lorsque les résistances internes R_{L} et R_{N} sont toutes deux connectées dans le circuit de traitement 20. Le schéma électrique simplifié du circuit de traitement 20 est affiché sur la figure 5, la flèche 50 indiquant le sens de circulation du courant électrique. Par exemple, cela correspond à un état fermé des thyristors 24 et 26.

Par exemple, cette séquence peut être omise dans le cas où, à l'issue des précédentes séquences, il a été déterminé que l'impédance ZdL et que l'impédance ZdN sont chacune inférieure ou égale à un seuil prédéterminé, par exemple 23 kilo ohms.

Dans cette séquence est directement mesurée l'impédance de court-circuit Zcc.

Les mesures de tension peuvent être acquises au moyen de convertisseurs analogique-numérique connectés à l'unité électronique de commande.

En pratique, pour la mesure de la tension, comme la terre réelle n'est pas accessible, les tensions V2 et V3 ne peuvent pas être mesurés directement, de sorte que sont mesurées les tensions entre le pont de diodes et les points hauts et bas de la sortie du circuit de traitement 20. Le courant peut être mesuré indirectement en mesurant la chute de tension à travers les résistances internes R_{L} et R_{N} pour calculer les courants I_{RL} et I_{RN} circulant au travers de ces résistances, respectivement.

D'autres implémentations sont possibles, par exemple lorsque le nombre de pôles du circuit est différent, par exemple dans le cas d'une installation polyphasée.

La figure 6 représente un exemple de fonctionnement du module de détection.

Le procédé débute lorsque l'appareil de protection 4 est déclenché suite à la détection d'un défaut électrique, tel qu'un court-circuit ou un défaut différentiel.

Par exemple, l'unité électronique de commande du module 12 détecte une perte d'alimentation en aval de l'appareil de protection 4, ou reçoit un signal de déclenchement émis par l'appareil de protection 4.

En réponse à ce déclenchement, à l'étape 100, l'unité électronique de commande reçoit un signal d'activation et commande la fermeture du relais d'isolation 14 pour connecter le circuit de traitement 20 aux conducteurs 6. Le circuit de traitement 20 est alors connecté électriquement au circuit aval.

D'une manière générale, il est possible utiliser soit le calcul d'impédances, soit un rapport de tension (car les valeurs de résistance interne et les mesures de tension entrée-sortie sont connues) pour déterminer le réarmement ou non.

Lors d'une étape 102, l'unité électronique de contrôle commande l'injection de signaux de test pour vérifier s'il y a un défaut de fuite à la terre ou un défaut de court-circuit dans le circuit aval, comme expliqué précédemment.

Lors d'une étape 104, pour chaque signal de test injecté, l'impédance du circuit aval connecté est déterminée par l'unité électronique de contrôle.

Les étapes 102 et 104 peuvent être répétées lorsque plusieurs signaux de test sont injectés successivement. Par exemple, trois séquences d'injection sont utilisées, comme décrit en référence aux figures 3, 4 et 5.

Lors d'une étape 106, sur la base des impédances calculées, l'unité électronique de commande détermine automatiquement si un défaut électrique (notamment court-circuit ou défaut différentiel) est présent dans le circuit aval.

Lors d'une étape 108, s'il est déterminé qu'il n'y a plus de défaut dans le circuit aval, alors l'unité de contrôle donne l'ordre à l'actionneur de refermer l'appareil de protection 4 (ordre de réenclenchement ou de réarmement).

Au contraire, si un défaut est détecté dans le circuit aval, alors l'appareil de protection 4 sera maintenu ouvert jusqu'à ce que le défaut soit éliminé. Par exemple, les étapes du procédé sont réitérées plus tard, par exemple après l'écoulement d'une durée prédéfinie, voire à intervalles répétés, par exemple périodiquement. On comprend donc que l'appareil de protection 4 n'est pas commuté et que l'actionneur n'est pas sollicité jusqu'à ce que le défaut soit éliminé.

Ces étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Grâce à l'invention, on dispose ainsi d'un module de détection d'un défaut électrique pour un appareil de protection électrique permettant de vérifier si l'appareil électrique peut être réenclenché en toute sécurité. La solution proposée est compacte et relativement simple et économique à fabriquer et à mettre en oeuvre. Elle permet en outre, de par sa construction pouvant être modulaire, d'être installée sur des appareils de protection électrique existants dans des installations électriques existantes.

Les modes de réalisation et les variantes envisagés ci-dessus peuvent être combinés entre eux pour créer de nouveaux modes de réalisation.

## Revendications

1. Module de détection d'un défaut électrique pour un appareil de protection électrique (4), ledit appareil de protection électrique étant adapté pour interrompre l'alimentation électrique d'une ou de plusieurs charge(s) électrique(s) connectée(s) dans une installation électrique (2) en aval de l'appareil de protection lors de la détection d'un défaut électrique par l'appareil de protection électrique, l'installation électrique comprenant au moins deux pôles (6) et comprenant, en aval de l'appareil de protection, un circuit électrique dit aval comprenant la ou les plusieurs charge(s) électrique(s), le module de détection étant configuré pour être connecté en parallèle de l'appareil de protection et comportant :
- un circuit de traitement (20) apte à identifier un défaut électrique, le circuit de traitement étant connectable aux pôles de l'installation électrique en amont dudit appareil de protection électrique ;
- un commutateur d'isolement (14) adapté à être connecté entre les pôles du circuit de traitement et l'installation électrique ;
- une unité électronique de commande (13) agencée pour commander le fonctionnement du commutateur d'isolement ;
dans lequel l'unité de commande (13) est agencée pour fermer le commutateur d'isolement et injecter une séquence de différents signaux de test dans les pôles du circuit de traitement lors de la détection d'une interruption de l'alimentation électrique par l'appareil de protection électrique,
dans lequel le circuit de traitement est agencé pour fournir au circuit de commande une séquence de signaux de tension proportionnels à des impédances de défaut selon le signal de test injecté par le module de commande,
et dans lequel un actionneur est agencé pour provoquer la reconnexion de l'alimentation électrique par l'appareil de protection électrique si les valeurs d'impédance du circuit aval calculées par l'unité de commande à partir des signaux de tension indiquent l'absence de défaut électrique dans l'installation électrique.

2. Module selon la revendication 1, dans lequel les impédances de défaut comportent une impédance de terre sous tension (Z_{dL}) entre la terre et une ligne de phase en aval de l'appareil de protection, une impédance de terre neutre (Z_{dN}) entre la terre et une ligne de neutre en aval de l'appareil de protection et une impédance de charge (Zcc) entre deux pôles en aval de l'appareil de protection.

3. Module selon l'une quelconque des revendications précédentes, dans lequel l'actionneur est adapté à être connecté audit appareil de protection électrique, la reconnexion de l'alimentation électrique par l'appareil de protection étant réalisée par l'actionneur en commutant les contacts séparables de l'appareil de protection vers leur état fermé.

4. Module selon l'une quelconque des revendications précédentes, dans lequel le circuit de traitement (20) comporte un pont de diodes redresseur (22) et des résistances internes (R_{L} et R_{N}) chacune connectée en série sur un des pôles entre le pont de diodes et une sortie du circuit de traitement raccordée au circuit aval, le circuit de traitement étant agencé pour que l'injection de différents signaux de test soit réalisée en connectant et déconnectant sélectivement et successivement certaines parties du circuit de traitement.

5. Module selon la revendication 4, dans lequel les pôles comportent au moins une ligne de phase et une ligne de neutre, et dans lequel l'unité électronique de commande est configurée pour que, lors d'une première séquence de test, un premier signal de test est injecté lorsque seule la résistance interne (R_{L}) associée à la ligne de phase est connectée dans le circuit de traitement et que la résistance interne (R_{N}) associée à la ligne de neutre est déconnectée.

6. Module selon la revendication 5, dans lequel l'unité électronique de commande est configurée pour que, lors d'une deuxième séquence, un deuxième signal de test est injecté lorsque seule la résistance interne (R_{N}) associée à la ligne de neutre est connectée dans le circuit de traitement et que la résistance interne (R_{L}) associée à la ligne de phase est déconnectée.

7. Module selon la revendication 6, dans lequel l'unité électronique de commande est configurée pour que, lors d'une troisième séquence, un troisième signal de test est injecté lorsque les résistances internes (R_{L}, R_{N}) sont toutes deux connectées dans le circuit de traitement pour mesurer directement l'impédance de court-circuit (Zcc).

8. Ensemble comportant un appareil de protection électrique et un module de détection d'un défaut électrique selon l'une quelconque des revendications précédentes, le module de détection étant intégré au sein de l'appareil de protection électrique.

9. Ensemble comportant un appareil de protection électrique et un module de détection d'un défaut électrique selon l'une quelconque des revendications 1 à 8, le module de détection étant intégré dans un module indépendant et associé électriquement et/ou mécaniquement à l'appareil de protection électrique.

10. Procédé de détection d'un défaut électrique pour un appareil de protection électrique, le module étant conforme à l'une quelconque des revendications précédentes, dans lequel le procédé de détection comporte des étapes consistant à :
- fermer le commutateur d'isolement et injecter une séquence de différents signaux de test dans les pôles du circuit de traitement lors de la détection d'une interruption de l'alimentation électrique par l'appareil de protection électrique,
- fournir au circuit de commande, par le circuit de traitement, une séquence de signaux de tension proportionnels à des impédances de défaut selon le signal de test injecté par le module de commande,
- provoquer la reconnexion de l'alimentation électrique par l'appareil de protection électrique si les impédances de défaut calculées par l'unité de commande à partir des signaux de tension indiquent l'absence de défaut électrique dans l'installation électrique.
